Europäisches Patentamt

European Patent Office

Office européen des brevets

(19)

(11) **EP 0 757 434 A1**

(12) **EUROPÄISCHE PATENTANMELDUNG**

(43) Veröffentlichungstag:
  **05.02.1997 Patentblatt 1997/06**

(51) Int. Cl.⁶: **H03F 3/193**

(21) Anmeldenummer: 96111805.6

(22) Anmeldetag: **23.07.1996**

(84) Benannte Vertragsstaaten:
  **AT DE ES FR GB IT SE**

(30) Priorität: **01.08.1995 AT 1310/95**

(71) Anmelder:
  • **Pritzl, Werner, Dipl.-Ing., Dr.**
   **1120 Wien (AT)**
  • **Ingruber, Bernard, Dipl.-Ing.**
   **2340 Mödling (AT)**

(72) Erfinder:
  • **Pritzl, Werner, Dipl.-Ing., Dr.**
   **1120 Wien (AT)**
  • **Ingruber, Bernard, Dipl.-Ing.**
   **2340 Mödling (AT)**

(74) Vertreter: **Stadler, Heinz, Dipl.-Ing.**
   **Weikersheimer Strasse 17**
   **70435 Stuttgart (DE)**

(54) **Hochfrequenz-Leistungsverstärker mit hohem Wirkungsgrad**

(57)    Die vorliegende Erfindung betrifft ein Verfahren und eine Vorrichtung zur Erzielung von Leistungsverstärkung mit hohem Wirkungsgrad im Hochfrequenz- und Mikrowellenbereich. Dabei wird ein zweistufiger Verstärker verwendet, bei dem der Transistor (104) der 2. Stufe, der in einem Klasse A Betrieb betrieben wird, mit einem halbsinusförmigen Signal angesteuert wird. Das halbsinus-förmige Signal am Gate des Transistors (104) der 2. Stufe wird mit einem Transistorverstärker generiert, der im Klasse B oder Klasse AB Betrieb betrieben wird und dessen Ausgang über Koppelkondensatoren (306) und (102) und einem Transformator (401) breitbandig mit dem Gate des Transistors (104) der 2. Stufe verbunden ist. Der Drain des Transistors (104) der 2. Stufe ist über einen Koppelkondensator (106) und über eine an sich von den Klasse F Verstärkern bekannte Schaltung (201), die alle geraden Harmonischen zwischen Drain und Source kurzschließt (202) und für alle ungeraden Harmonischen einen Leerlauf erzeugt (203), mit dem Lastwiderstand (110) verbunden.

Fig. 5a

**Beschreibung**

Die gegenständliche Erfindung betrifft ein Verfahren und eine Vorrichtung zur Erzielung von Leisungsverstärkung mit hohem Wirkungsgrad im Hochfrequenz- und Mikrowellenbereich, wie sie beispielsweise im Bereich der Mobil- und Satellitenkommunikation von großer Bedeutung ist.

In der Hochfrequenz- und Mikrowellentechnik sind verschiedene Beschaltungen von Transistoren bekannt, um Signale zu verstärken. Im folgenden werden die Verhältnisse bei Feldeffekttransistoren (FET) beschrieben, die beschriebenen Verfahren können aber auch bei Bipolartransistoren verwendet werden.

Bei den Klasse A Verstärkern wird der Arbeitspunkt des Transistors so gewählt, daß unabhängig vom Momentanwert des Eingangssignals immer ein Drainstrom durch den Transistor fließt. Mit klassischen Klasse A Verstärkern kann bestenfalls ein Dran-Wirkungsgrad $\eta_D$, bei dem die Ausgangsleistung $P_{AUS}$ bei der gewünschten Hochfrequenz mit der Leistungsaufnahme $P_O$, die sich aus dem Produkt von Gleichanteil der Drain-Source-Spannung $U_{DSO}$ und Gleichanteil des Drainstroms $I_{DO}$ errechnet, ins Verhältnis gesetzt wird

$$\eta_D = \frac{P_{AUS}}{P_O} \, ,$$

von 50% erzielt werden (H. L. Krauss, Ch. W. Bostian, F. H. Raab: Solid State Radio Engineering, John Wiley & Sons, New-York, 1980; Gleichung 12-7). Berücksichtigt man im Wirkungsgrad nur die gewonnene Hochfrequenzleistung, das ist die Ausgangsleistung $P_{AUS}$ weniger der Eingangsleistung $P_{EIN}$ bei der gewünschten Hochfrequenz, so erhält man einen noch kleineren Wirkungsgrad

$$\eta = \frac{P_{AUS} - P_{EIN}}{P_O} = \left(1 - \frac{P_{EIN}}{P_{AUS}}\right) \cdot \frac{P_{AUS}}{P_O} = \left(1 - \frac{1}{G}\right) \cdot \eta_D,$$

der von der Leistungsverstärkung G des Verstärkers abhängt.

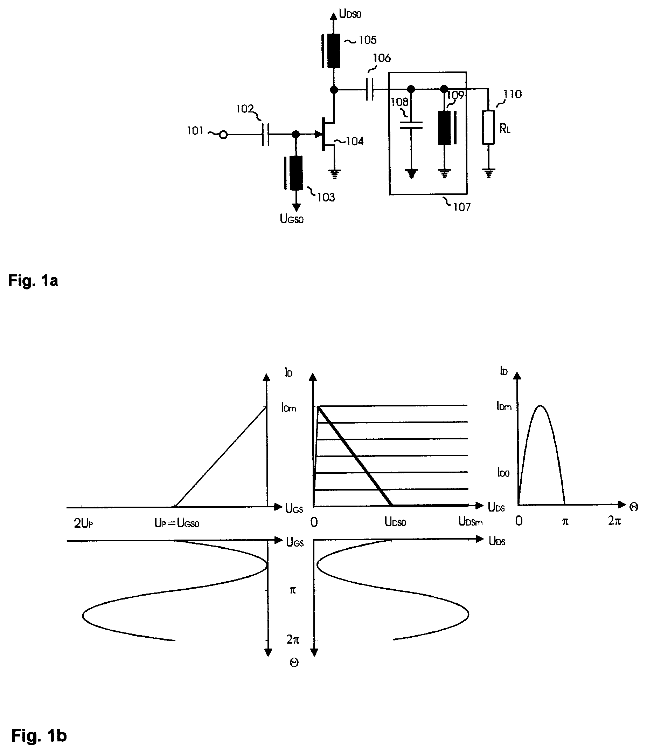

Klasse B Verstärker sind dadurch gekennzeichnet, daß bei ihnen nur während 50% der Zeit ein Strom durch den Transistor fließt. Das wird dadurch erreicht, daß die Gate-Source-Vorspannung $U_{GSO}$ gleich der Abschnürspannung $U_P$ ist. Fig. 1a zeigt die Schaltung eines Klasse B Verstärkers, in Fig. 1b sind ein idealisiertes Kennlinienfeld eines FETs, die Gate-Source-Spannung $U_{GS}$, die Drain-Source-Spannung $U_{DS}$ und der Drainstrom $I_D$ des Transistors (104) in Abhängigkeit der Phase $\Theta = \omega t$ (Kreisfrequenz $\omega$, Zeit $t$) dargestellt. Der Drainstrom des Transistors (104) ist halbsinusförmig, die an ihm anliegende Drain-Source-Spannung ist weiter sinusförmig. Am Ausgang des klassischen Klasse B Verstärkers wird durch eine Koppelkapazität (106) und eine Frequenzselektionsschaltung (107), die aus der Parallelschaltung einer Kapazität (108) und einer Induktivität (109) auf Masse besteht, welche bei der Betriebsfrequenz in Resonanz sind, sichergestellt, daß nur die gewünschte Frequenz an den Lastwiderstand (110) geliefert wird. Mit diesem Verfahren kann ein Drain-Wirkungsgrad von 78,5% (H. L. Krauss, Ch. W. Bostian, F. H. Raab: Solid State Radio Engineering, John Wiley & Sons, New-York, 1980; Gleichung 12-15) erreicht werden. Allerdings muß die Amplitude des Eingangssignals doppelt so groß sein wie bei klassischen Klasse A Verstärkern. Da die Ausgangsleistung gleich groß ist wie beim klassischen Klasse A Verstärker, wird die Spannungsverstärkung nur halb so groß und die Leistungsverstärkung nur ein viertel so groß wie bei Klasse A Verstärkern, was eine Einbuße in der Verstärkung von 6dB gegenüber Klasse A bedeutet. Dadurch wird auch der Wirkungsgrad für die gewonnene Hochfrequenzleistung in stärkerem Maß als bei Klasse A Verstärkern gegenüber dem Dran-Wirkungsgrad erniedrigt. Eine weitere Folge der geringeren Verstärkung ist die Tatsache, daß für die gleiche Verstärkung mehr Verstärkerstufen erforderlich sind, was zu mehr Bauteilen, höherer Masse und damit zu höheren Kosten führt.

Um diese Nachteile etwas auszugleichen, wird oft auch das Klasse AB Verfahren verwendet, bei dem durch die Wahl der Gate-Source-Vorspannung $U_{GSO}$ die Zeit, in der ein Drainstrom durch den Transistor fließt, zwischen 50% und 100% liegt. Auf der anderen Seite gibt es auch das Klasse C Verfahren, bei dem die Zeit, in der Drainstrom durch den Transistor fließt, weniger als 50% beträgt, was zu einer weiteren Erhöhung des Drain-Wirkungsgrads, allerdings verbunden mit einer weiteren Verringerung der Verstärkung, führt.

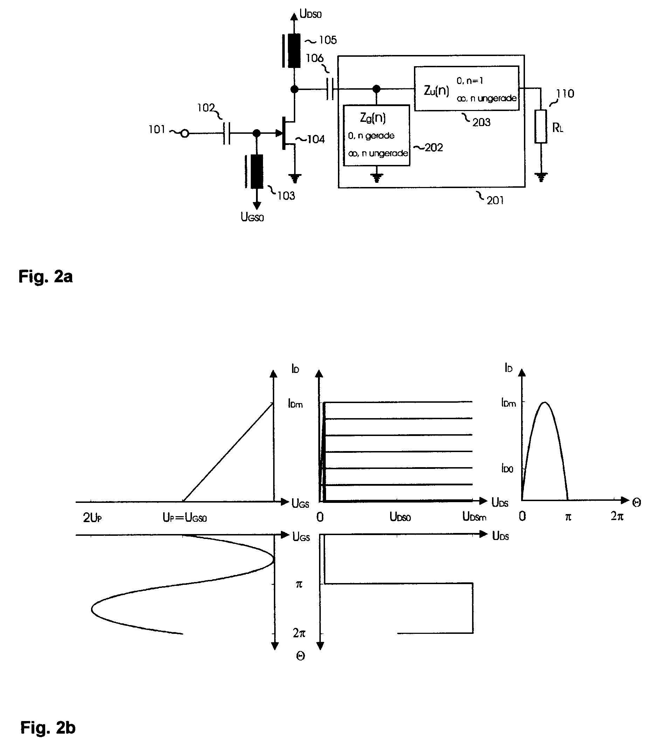

David M. Snider ("A Theoretical Analysis and Experimental Confirmation of the Optimally Loaded and Overdriven RF Power Amplifier", IEEE Transactions on Electron Devices, Vol. ED-14, No. 12, December 1967, 851 - 857) zeigt, daß der Drain-Wirkungsgrad, ausgehend von einem klassischen Klasse B Verstärker, auf 100% erhöht werden kann. Die prinzipielle Schaltung eines solchen Verstärkers, der oft mit Klasse F bezeichnet wird, zeigt Fig. 2a. Die dazugehörigen Signalverläufe sind in Fig. 2b gezeigt. Der Drainstrom $I_D$ ist in diesem Fall wieder halbsinusförmig, die Drain-Source-Spannung $U_{DS}$ ist nun aber rechteckförmig. Das wird dadurch erreicht, daß an Stelle der Frequenzselektionsschaltung (107) beim klassischen Klasse B Verstärker eine Schaltung (201) verwendet wird, die alle geraden Harmonischen zwischen Drain und Source kurzschließt (202) und für alle ungeraden Harmonischen einen Leertauf erzeugt (203). Es gelangt wieder nur die Grundwelle zum Lastwiderstand (110). D. M. Snider zeigt auch, daß die Ausgangsleistung um den Faktor 4/π (entspricht 1dB) größer als beim klassischen Klasse B Verstärker ist (vergleiche Gleichung 15). Da weiters die Eingangsleistung gleich wie bei klassischen Klasse B Verstärkern ist, beträgt die Verstärkung des idealen Klasse F Verstärkers 5dB weniger als die eines klassischen Klasse A Verstärkers. In der Praxis können die Harmonischen nur bis zu einer gewissen Ordnung, meist bis zur 2. oder 3. Harmonischen, in der oben beschriebenen Weise abgeschlossen werden, wodurch sich der Drain-Wirkungsgrad etwas verringert. Einige praktische Schaltungen sind beispielsweise im Patent US 4,717,884 und in der europäischen Patentanmeldung mit der Veröffentlichungsnummer 0 467 270 A1 angegeben. Als Nachteil muß wieder erwähnt werden, daß auch beim Klasse F Verfahren die Verstärkung viel kleiner als bei klassischer Klasse A ist.

Der Drain-Wirkungsgrad von 100% beim Klasse F Verstärker wird dadurch erreicht, daß abwechslungsweise der Drainstrom oder die Drain-Source-Spannung gleich null sind und somit keine Verlustleistung im Transistor entsteht. Auf dem gleichen Prinzip, nämlich daß entweder der Drainstrom oder die Drain-Source-Spannung null sind, beruhen die Klasse E Verstärker, allerdings unterscheiden sich dabei die Schaltung am Ausgang des Transistors und somit auch die zeitlichen Verläufe des Drainstroms und der Drain-Source-Spannung von denen der Klasse F Verstärker. Das Klasse E Prinzip wird beispielsweise von N. O. Sokal und A. D. Sokal ("Class E, a New Class of High-Efficiency Tuned Single-Ended Power Amplifiers", IEEE Journal of Solide State Circuits, Vol. SC-10, 168 - 176, June 1975) behandelt. Der Nachteil dieses Verfahrens ist, daß bei ihm sehr hohe Drain-Source-Spannungen auftreten.

Ein weiteres Verfahren wird im Patent US5,172,072 vorgestellt. Dabei werden neben dem eigentlichen Verstärker für die Grundfrequenz zusätzliche Frequenzvervielfacher und Verstärker verwendet, um Harmonische des Eingangssignals zu erzeugen, getrennt zu verstärken und in der richtigen Phasenlage dem Ausgang des eigentlichen Verstärkers für die Grundfrequenz zuzuführen. Der Vorteil dieses Verfahrens ist, daß es auch für größere Bandbreiten realisiert werden kann, allerdings ist der Schaltungsaufwand sehr groß.

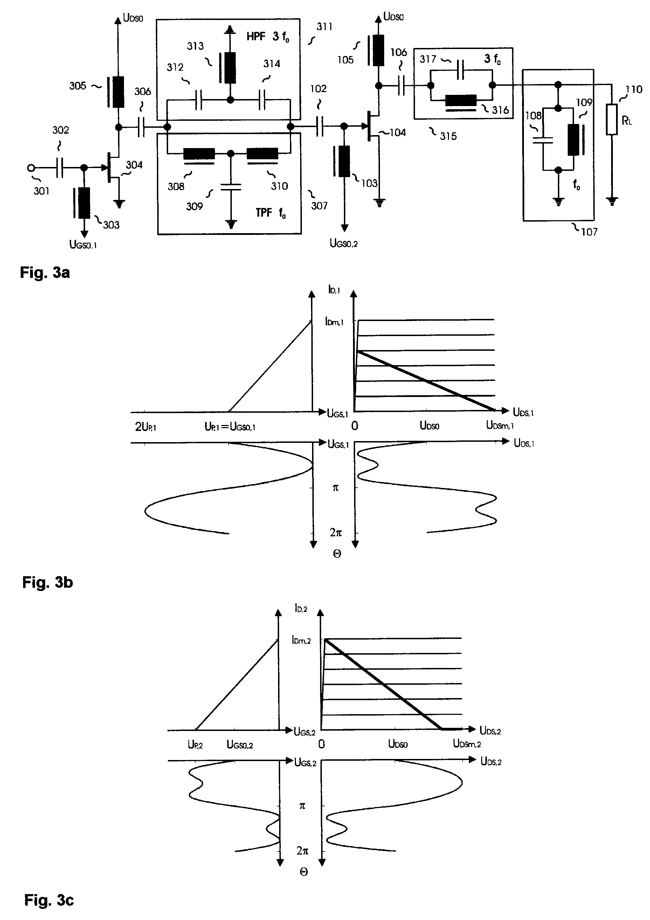

Im Patent FR 2 683 686 wird vorgeschlagen, bei einem zweistufigen Verstärker den Transistor der zweiten Stufe, der in Klasse A betrieben wird, mit einem annähernd rechteckförmigen Signal anzusteuern, um einen hohen Wirkungsgrad in Kombination mit einer hohen Verstärkung zu erzielen. Eine etwas vereinfachte Schaltungsskizze dazu ist in Fig. 3a angegeben. Die dem Patent entnommenen Spannungsverläufe sind in Fig. 3b für den Transistor der ersten Stufe und in Fig. 3c für den Transistor der zweiten Stufe wiedergegeben.

Die erste Stufe, die aus einem Koppelkondensator am Gate (302), einer Spannungszuführung zum Gate (303), dem Transistor (304), der Spannungszuführung zum Drain (305) und einem Koppelkondensator am Ausgang (306) besteht, wird wie ein Klasse B Verstärker angesteuert. Durch die Wahl der Lastimpedanz wird das Eingangssignal begrenzt, und es kommt zu einer annähernd rechteckförmigen Ausgangsspannung. Zwischen der 1. Stufe und der 2. Stufe befindet sich eine Parallelschaltung aus einem Tiefpaßfilter (307) für die Grundfrequenz, bestehend aus einem T-Glied mit zwei Induktivitäten (308) (310) und einer Kapazität (309), und einem Hochpaßfilter (311) für die 3. Harmonische, bestehend aus einem T-Glied mit zwei Kapazitäten (312) (314) und einer Induktivität (313). Dadurch wird erreicht, daß die Grundfrequenz und die 3. Harmonische zum Gate des Transistors (104) der 2. Stufe, der in Klasse A betrieben wird, gelangen und sich dort zu einem annähernd rechteckförmigen Eingangssignal summieren. Beim Dran des Transistors (104) der 2. Stufe ist zwischen dem Koppelkondensator (106) und der Frequenzselektionsschaltung (107) noch ein Sperrkreis (315) eingefügt, der aus der Parallelschaltung einer Induktivität (316) und einer Kapazität (317) besteht, die bei der 3. Harmonischen in Resonanz sind. Dieser Sperrkreis (315) stellt in Verbindung mit der Frequenzselektionsschaltung (107) eine Annäherung an ein Klasse F Ausgangsnetzwerk dar, das bei der 3. Harmonischen einen Leerlauf erzeugt und die 2. und alle höheren Harmonischen kurzschließt.

Würde der Transistor der 2. Stufe mit einem ideal rechteckförmigen Signal angesteuert werden, dann würde genau 50% der Zeit ein Drainstrom fließen, und der von den Klasse F Verstärkern bekannte, hohe Wirkungsgrad könnte in Kombination mit der Verstärkung eines Klasse A Verstärkers erzielt werden. Durch die endliche Flankensteilheit des nur annähernd rechteckförmigen Eingangssignals ist allerdings zu erwarten, daß mehr als 50% der Zeit ein Drainstrom fließt, und deshalb der gewünschte, hohe Wirkungsgrad nicht erreicht werden kann. Sachihiro Toyoda verwendet bei seinen mehrstufigen Verstärkern gleichfalls annähernd rechteckförmige Signale ("High Efficiency Single and Push-Pull Power Amplifiers", IEEE MTT-S International Microwave Symposium Digest, 1993, Vol. 1, 277 - 280 und "High Efficiency Amplifiers", IEEE MTT-S International Microwave Symposium Digest, 1994, Vol. 1, 253 - 256), betreibt die damit angesteuerten Transistoren allerdings in Klasse C, damit weniger als 50% der Zeit ein Drainstrom fließt und somit wieder ein hoher Wirkungsgrad erreicht werden kann. Die Verstärkung ist dabei natürlich wieder geringer.

All diese Verfahren erzielen den hohen Wirkungsgrad nur bei der maximalen Ein- und Ausgangshochfrequenzleistung. Bei kleineren Hochfrequenzleistungen, wie sie bei Signalen mit variabler Einhüllenden, wie zum Beispiel AM- oder Mehrträgersignalen auftreten, sinkt der Wirkungsgrad. Bei klassischen Klasse A Verstärkern ist der Wirkungsgrad proportional der Hochfrequenzleistung, da die Leistungsaufnahme unabhängig von der Hochfrequenzleistung konstant ist. Bei klassischen Klasse B und bei Klasse F Verstärkern ist der Gleichstromanteil des Drainstroms $I_{DO}$ proportional der Einhüllenden des Hochfrequenzsignals, wodurch Leistungsaufnahme und Wirkungsgrad proportional der Wurzel der Hochfrequenzleistung werden (die Drain-Source-Spannung ist auch hier konstant). Die Verschlechterung des Wirkungsgrads ist also bei klassischen Klasse B und Klasse F Verstärkern geringer als bei klassischen Klasse A Verstärkern. Adel A. Saleh und Donald C. Cox ("Improving the Power-Added Efficiency of FET Amplifiers Operating with Varying-Envelope Signals", IEEE Transactions on Microwave Theory and Techniques, Vol. 31, No. 1, 51 - 56, January 1983) schlagen deshalb bei einem klassischen Klasse A Verstärker vor, vor dem Eingang des eigentlichen Verstärkers einen Richtkoppler vorzusehen und die Einhüllende des Hochfrequenzsignals zu messen, um damit die Gate-Source-Vorspannung $U_{GSO}$ und somit auch den Gleichanteil des Drainstroms $I_{DO}$ eines FETs so zu steuern, daß nur der gerade notwendige Drainstrom fließt. Damit kann wieder eine Proportionalität zwischen der Leistungsaufnahme bzw. dem Wirkungsgrad und der Wurzel der Hochfrequenzleistung erreicht werden.

Der vorliegenden Erfindung liegt das Ziel zu Grunde, ein neues Verfahren zu finden, das die Vorteile des Klasse B bzw. Klasse F Verstärkers, nämlich den hohen Drain-Wirkungsgrad mit der hohen Verstärkung der Klasse A Verstärker kombiniert, um einen noch höheren Wirkungsgrad für die gewonnene Hochfrequenzleistung zu erreichen, und eine Schaltung anzugeben, mit der dieses neue Schaltungskonzept realisiert werden kann.

Das neue Verfahren beruht darauf, daß bei einem zweistufigen Verstärker die zweite Stufe, die im Klasse A Betrieb betrieben wird, von einem näherungsweise halbsinusförmigen Signal angesteuert wird, das von der ersten Verstärkerstufe generiert wird. Das halbsinusförmige Signal am Eingang der zweiten Stufe läßt sich gut durch die Überlagerung eines Signals bei der Grundfrequenz und eines Signals bei der zweiten Harmonischen annähern. Auf diese Weise kann überraschenderweise eine Verstärkung ähnlich dem Klasse A Verfahren bei einem Drain-Wirkungsgrad des Klasse B bzw. Klasse F Verfahrens und damit ein entsprechend höherer Wirkungsgrad für die gewonnene Hochfrequenzleistung erreicht werden, wie noch gezeigt wird. Ein weiterer Vorteil liegt darin, daß beim Transistor der zweiten Stufe keine so negativen Gate-Source-Spannungen auftreten, was sich positiv auf seine Lebensdauer auswirkt.

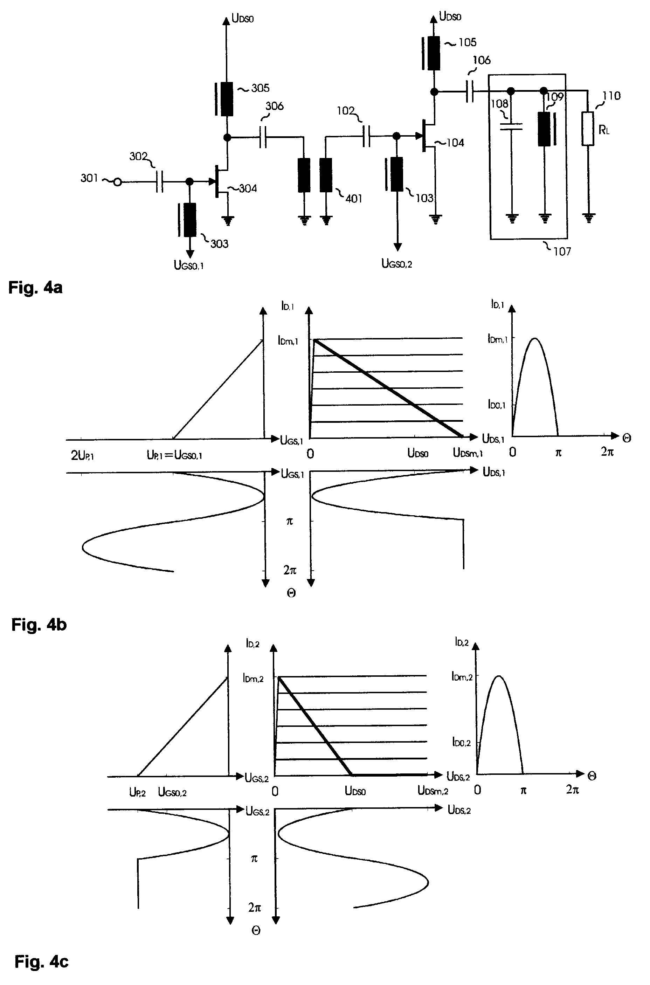

Das Verfahren wird durch ein Blockschaltbild in Fig. 4a und durch die auftretenden Signale am Transistor (304) der 1. Stufe in Fig. 4b und jene am Transistor (104) der zweiten Stufe in Fig. 4c veranschaulicht:

Der Eingang des Verstärkers (301) ist über einen Koppelkondensator (302) mit dem Gate des Transistors (304) der 1. Stufe verbunden, das über eine Spannungszuführung (303), die die Hochfrequenz abblockt, mit einer Gate-Source-Vorspannung $U_{GSO,1}$ beaufschlagt wird, die etwa der Abschnürspannung $U_{P,1}$ entspricht (Klasse B oder Klasse AB). Die Source des Transistors (304) der 1. Stufe ist mit Masse verbunden, der Drain ist über eine Spannungszuführung (305), die wieder die Hochfrequenz abblockt, mit der positiven Versorgungsspannung $U_{DSO}$ verbunden. Zwischen dem Drain des Transistors (304) der 1. Stufe und dem Gate des Transistors (104) der 2. Stufe befinden sich Koppelkondensatoren (306) und (102) und zwischen ihnen ein mit Masse verbundener Transformator (401), der den Eingangswiderstand der 2. Stufe breitbandig auf den optimalen Lastwiderstand der 1. Stufe transformiert. Das Gate des Transistors (104) der 2. Stufe ist weiters über eine Spannungszuführung (103), die wieder die Hochfrequenz abblockt, mit einer Gate-Source-Vorspannung $U_{GSO,2}$ verbunden, die etwa 0.7 mal die Abschnürspannung $U_{P,2}$ beträgt (modifizierter Klasse A Betrieb), die Source des Transistors (104) der 2. Stufe ist wieder mit Masse verbunden, der Drain ist über eine Spannungszuführung (105), die wieder die Hochfrequenz abblockt, mit der positiven Versorgungsspannung $U_{DSO}$ verbunden. Der Drain des Transistors (104) der 2. Stufe ist weiters über einen Koppelkondensator (106) und weiter über eine Frequenzselektionsschaltung (107), die aus der Parallelschaltung einer Kapazität (108) und einer Induktivität (109) auf Masse besteht, welche bei der Betriebsfrequenz in Resonanz sind, mit dem Lastwiderstand (110) verbunden.

Wenn man berücksichtigt, daß der transformierte Eingangswiderstand der 2. Stufe einen Lastwiderstand darstellt, erkennt man, daß die 1. Stufe des Verstärkers einem Klasse B Verstärker, wie er in Fig. 1a dargestellt ist, entspricht, bei dem die Frequenzselektionsschaltung (107) weggelassen ist. Durch das Weglassen der Frequenzselektionsschaltung werden sowohl der Drainstrom $I_{D,1}$, als auch die Drain-Source-Spannung $U_{DS,1}$ halbsinusförmig. Ein halbsinusförmiges Signal $y_{halbsinus}(\omega t)$ mit einem maximalen Wert von 1 kann man mittels einer Fourierreihe darstellen:

$$y_{halbsinus}(\omega t) = \frac{1}{\pi} + \frac{1}{2} \cdot \left( \sin(\omega t) - \frac{4}{3\pi} \cdot \cos(2\omega t) - \frac{4}{15\pi} \cdot \cos(4\omega t) - \ldots \right).$$

Da die Amplitude der Grundfrequenz gleich der halben maximalen Spannung $U_M$ ist, ist die Ausgangsleistung bei der Grundfrequenz gleich wie beim klassischen Klasse B Verstärker. Da auch das Eingangssignal gleich wie beim klassischen Klasse B Verstärker ist, ist auch die Verstärkung gleich, nämlich 6 dB unter der Verstärkung eines Klasse A Verstärkers. Der Drain-Wirkungsgrad ergibt sich aus dem Quotienten von Ausgangsleistung bei der Grundfrequenz $P_{AUS}$ und Leistungsaufnahme $P_O$:

$$\eta_D = \frac{P_{AUS}}{P_O} = \frac{\frac{1}{2} \cdot \frac{1}{2} V_M \cdot \frac{1}{2} I_M}{\left(1 - \frac{1}{\pi}\right) V_M \cdot \frac{1}{\pi} I_M} = \frac{\pi^2}{8 \cdot (\pi - 1)} = 57.6\%.$$

Die 2. Stufe wird in einem Klasse A Betrieb betrieben. Dabei wird allerdings im Gegensatz zum klassischen Klasse A Verstärker ein Gleichanteil des Drainstroms $I_{DO,2}$ von $1/\pi \approx 0.32$ des maximalen Drainstroms $I_{Dm,2}$ verwendet. Am Eingang ist die Amplitude bei der Grundfrequenz halb so groß wie beim klassischen Klasse B Verstärker und somit gleich groß wie beim klassischen Klasse A Verstärker. Da weiters die Ausgangsleistung gleich wie beim klassischen Klasse B bzw. klassischen Klasse A Verstärker ist, ist die Verstärkung gleich groß wie beim klassischen Klasse A Verstärker. Da die Ausgangssignale der 2. Stufe gleich wie beim klassischen Klasse B Verstärker sind, ist auch der Drain-Wirkungsgrad gleich wie beim klassischen Klasse B Verstärker, nämlich 78.5%.

Der Wirkungsgrad für die gewonnene Hochfrequenzleistung läßt sich für einen zweistufigen Verstärker folgendermaßen berechnen:

$$\eta = \frac{P_{AUS,2} - P_{EIN,1}}{P_{O,2} + P_{O,1}} = \frac{P_{AUS,2} - \dfrac{P_{AUS,2}}{G_1 \cdot G_2}}{\dfrac{P_{AUS,2}}{\eta_{D,2}} + \dfrac{P_{AUS,2}}{G_2 \cdot \eta_{D,1}}} = \frac{1 - \dfrac{1}{G_1 \cdot G_2}}{\dfrac{1}{\eta_{D,2}} + \dfrac{1}{G_2 \cdot \eta_{D,1}}}.$$

Nimmt man für die Klasse A Verstärkung 15dB an, wie sie beispielsweise für Leistungs-GaAs-FETs bei 2GHz typisch ist, erhält man mit $G_{1,dB}$ = 9dB, $G_{2,dB}$ = 15dB, $\eta_{D,1}$ = 57.6% und $\eta_{D,2}$ = 78.5% für den neuen, zweistufigen Verstärker gemäß Fig. 4a bis Fig. 4c einen Wirkungsgrad für die gewonnene Hochfrequenzleistung von 75.7%. Das ist deutlich mehr als 68.0%, die man für einen zweistufigen Verstärker aus klassischen Klasse B Verstärkern erhält ($G_{1,dB}$ = $G_{2,dB}$ = 9dB, $\eta_{D,1}$ = $\eta_{D,2}$ = 78.5%), und auch die Gesamtverstärkung ist um 6dB größer.

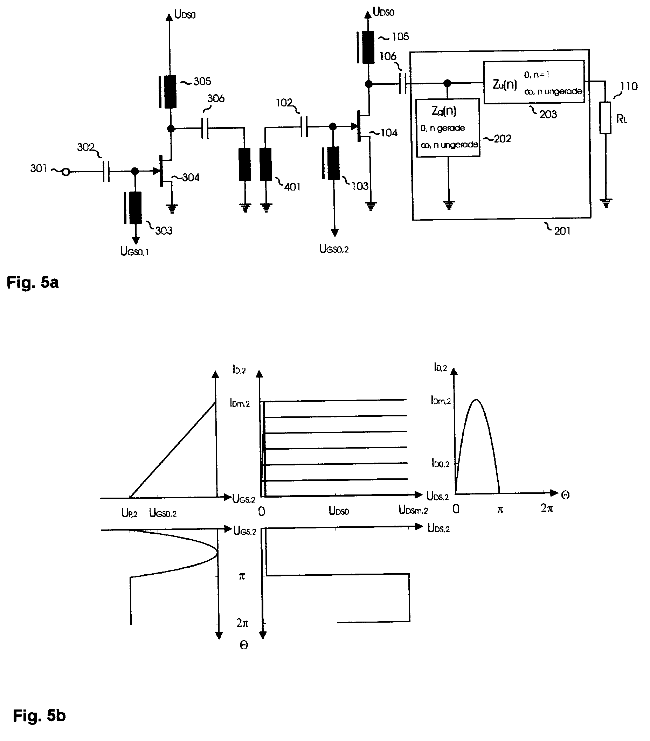

Das erfindungsgemäße Verfahren läßt sich weiter verbessern, indem statt der Frequenzselektionsschaltung (107) am Ausgang des Transistors der zweiten Stufe eine an sich von den Klasse F Verstärkern bekannte Schaltung (201) verwendet wird, die alle geraden Harmonischen zwischen Drain und Source kurzschließt (202) und für alle ungeraden Harmonischen einen Leerlauf erzeugt (203). Dieses Schaltungsprinzip ist in Fig. 5a dargestellt, die Signalformen für die 2. Stufe sind in Fig. 5b abgebildet.

Wie zuvor ist am Eingang der 2. Stufe die Amplitude bei der Grundfrequenz halb so groß wie beim klassischen Klasse B Verstärker und somit gleich groß wie beim Klasse A Verstärker. Da die Signalformen am Ausgang, nämlich der Drainstrom $I_{D,2}$ und die Drain-Source-Spannung $U_{DS,2}$, gleich wie beim Klasse F Verstärker sind, ist auch wieder die Ausgangsleistung um 1dB größer als beim Klasse B bzw. Klasse A Verstärker. Daraus folgt, daß in diesem Fall die Verstärkung sogar um 1dB über der Verstärkung des klassischen Klasse A Verstärkers liegt. Der Drain-Wirkungsgrad beträgt auf Grund der gleichen Signalformen am Ausgang wie beim Klasse F Verstärker 100%.

Für den zweistufigen Verstärker nach den Fig. 5a und Fig. 5b erhält man damit einen Wirkungsgrad für die gewonnene Hochfrequenzleistung von 95.5% ($G_{1,dB}$ = 9dB, $G_{2,dB}$ = 16dB, $\eta_{D,1}$ = 57.6% und $\eta_{D,1}$ = 100%)! Dem gegenüber erhält man für einen zweistufigen Verstärker, der aus zwei Klasse F Verstärkern besteht, nur einen Wirkungsgrad für die gewonnene Hochfrequenz von 90.0% ($G_{1,dB}$ = $G_{2,dB}$ = 10dB, $\eta_{D,1}$ = $\eta_{D,2}$ = 100%). Auch die Verstärkung des erfindungsgemäßen Verstärkers ist mit 25dB wieder deutlich höher als die Verstärkung von 2 Klasse F Verstärkern mit 20dB.

Der erfindungsgemäße Verstärker unterscheidet sich in seiner Funktionsweise wesentlich von dem im Patent FR 2 683 686 angegebenen Verstärker. Beim Verstärker aus Patent FR 2 683 686 wird eine Ansteuerung des Transistors (104) der 2. Stufe mit einem annähernd rechteckförmigen Signal angestrebt, beim erfindungsgemäßen Verstärker wird dieser Transistor mit einem annähernd halbsinusförmigen Signal angesteuert. Damit kann mit dem erfindungsgemäßen Verstärker im Gegensatz zum Verstärker aus Patent FR 2 683 686 erreicht werden, daß nur 50% der Zeit ein Drainstrom fließt, was wieder Voraussetzung für die Erzielung eines hohen Wirkungsgrads ist. Auch bei den Schaltungen gibt es wesentliche Unterschiede zwischen dem Verstärker aus Patent FR 2 683 686 und dem erfindungsgemäßen Verstärker. Während beim Verstärker aus Patent FR 2 683 686 bei der Grundwelle und bei der 3. (und höheren) Harmonischen eine Verbindung zwischen der 1. und 2. Verstärkerstufe besteht, ist beim erfindungsgemäßen Verstärker die Verbindung bei der Grundwelle und bei der 2. Harmonischen wesentlich. Das führt dazu, daß beim Verstärker aus Patent FR 2 683 686, selbst wenn der Transistor (304) das Signal nicht begrenzen würde, sich am Gate des Transistors (104) der zweiten Stufe kein annähernd halbsinusförmiges Signal einstellen könnte, da das Tiefpaßfilter (307) und das Hochpaßfilter (311) die für die Ausbildung eines halbsinusförmigen Signals wesentlichen 2. Harmonische unterdrücken.

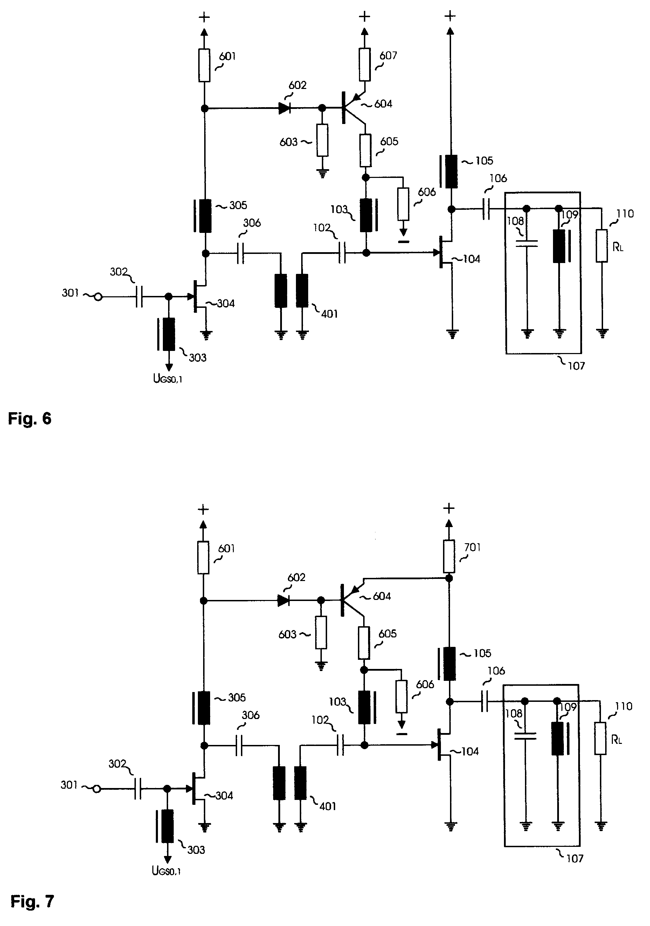

Für Hochfrequenzsignale mit variabler Einhüllender läßt sich für die 2. Stufe, die ja im Klasse A Betrieb betrieben wird, das an sich bekannte Verfahren der Steuerung der Gate-Source-Vorspannung und damit des Drainstroms durch die Einhüllende des Hochfrequenzsignals zur Erhöhung des Wirkungsgrads überraschenderweise besonders vorteilhaft anwenden. Fig. 6 zeigt eine neue, erfinderische Prinzipschaltung, bei der die Amplitude der Einhüllenden des Eingangssignals aus dem Gleichanteil des Drainstrom des Transistors der 1. Stufe $I_{DO,1}$ abgeleitet wird, indem zwischen Versorgungsspannung $U_{DSO}$ und Spannungszuführung (305) zum Drain des Transistors der 1. Stufe ein sehr kleiner Widerstand (601) eingefügt wird, an dem eine kleine Spannung proportional der Einhüllenden abfällt. Durch eine Diode (602), deren Anode mit dem Widerstand (601) und mit der Spannungszuführung (305) zum Drain des Transistors der 1. Stufe und deren Katode mit einem sehr hohen, mit Masse verbundenen Widerstand (603) verbunden ist, wird eine um eine Flußspannung eines pn-Übergangs größere Spannung erzeugt. Mit dieser Spannung wird die Basis eines pnp-Bipolartransistors (604) angesteuert, dessen Emitter über einen Widerstand (607) mit der positiven Versorgungsspannung $U_{DSO}$ verbunden ist. Die Spannungszuführung zum Gate (103) der 2. Stufe ist nun über einen Widerstand (605) mit dem Kollektor des pnp-Bipolartransistors (604) und über einen Widerstand (606) mit einer negativen Versorgungsspannung verbunden, die etwa gleich der Abschnürspannung $U_{P,2}$ der Transistors (104) der 2. Stufe ist. Durch diese Prinzipschaltung wird eine Gate-Source-Vorspannung $U_{GSO,2}$ erzeugt, die sich linear mit der Einhüllenden des Hochfrequenzsignals ändert. Damit wird eine Proportionalität zwischen der Leistungsaufnahme bzw. dem Wirkungsgrad und der Wurzel der Hochfrequenzleistung erreicht. Der Widerstand (605) dient als Schutz vor zu hohen Gate-Source-Spannugen beim Ein- und Ausschalten. Die höchste in der Schaltung (601) bis (607) auftretende Frequenz ist die höchste Frequenz der Einhüllenden des Hochfrequenzsignals und somit gleich der Bandbreite des Hochfrequenzsignals.

Die soeben beschriebene Schaltung läßt sich leicht zu einer Schaltung umbauen, die nicht die Gate-Source-Vorspannung steuert, sondern den Drainstrom des Transistors (104) der 2. Stufe $I_{DO,2}$ regelt. Bei dieser in Fig. 7 gezeigten Schaltung wird der Emitter des Transistors (604) nicht mit dem Widerstand (607) verbunden, sondern mit der Spannungszuführung (105) zum Drain des Transistors der 2. Stufe, die nun über einen sehr kleinen Widerstand (701) mit der positiven Versorgungsspannung verbunden ist. Durch diese Schaltung wird erreicht, daß sich der Drainstrom in der 2. Stufe zum Drainstrom in der 1. Stufe verhält wie der Widerstand (601) zum Widerstand (701) und somit proportional zur Einhüllenden des Hochfrequenzsignals wird. Wie bei der vorigen Schaltung wird auch hier eine Proportionalität zwischen der Leistungsaufnahme bzw. dem Wirkungsgrad und der Wurzel der Hochfrequenzleistung erreicht. Im Unterschied zu der vorigen Schaltung arbeitet diese Schaltung jedoch unabhängig von der Abschnürspannung des Transistors der 2. Stufe $U_{P,2}$.

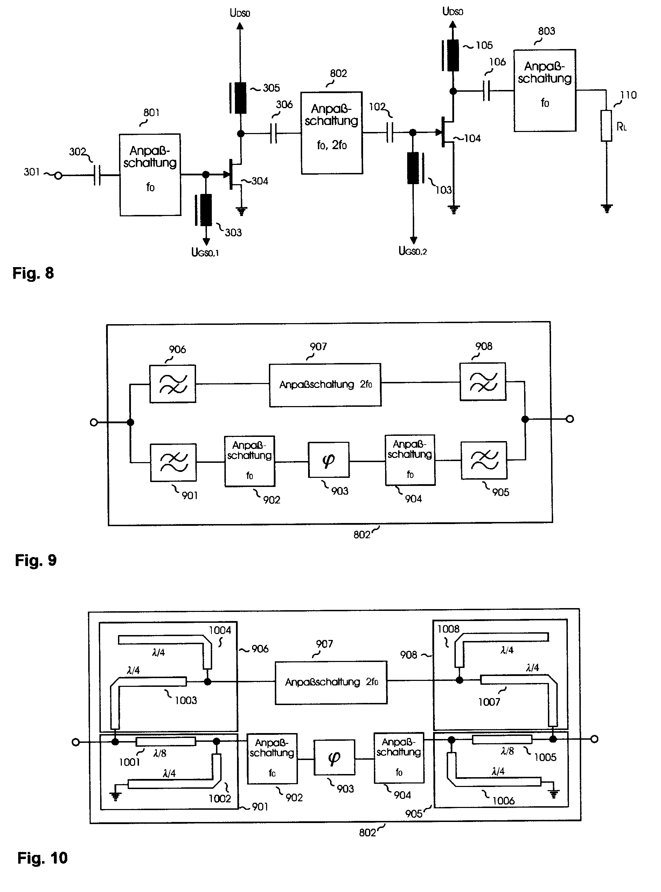

Bei hohen Frequenzen, insbesondere im Mikrowellenbereich, haben Transistoren nicht mehr reelle Ein- und Ausgangswiderstände, wie es bis jetzt vorausgesetzt wurde. Wegen der internen Kapazitäten und der Anschlußdrähte treten erhebliche Blindanteile auf. Deshalb sind in der Hochfrequenz- und Mikrowellentechnik Anpaßschaltungen notwendig, die die Blindanteile kompensieren und das Widerstandsniveau entsprechend transformieren. Fig. 8 zeigt eine Schaltung des erfindungsgemäßen, zweistufigen Verstärkers, in der solche Anpaßschaltungen vorgesehen sind. Am Eingang befindet sich zwischen dem Koppelkondensator (302) und dem Gate des Transistors (304) der 1. Stufe eine Anpaßschaltung (801), die für die Grundfrequenz in bekannter Weise dimensioniert ist. Der breitbandige Transformator zwischen dem Koppelkondensator (306) am Drain der 1. Stufe und dem Koppelkondensator (102) am Gate der 2. Stufe wird durch eine Anpaßschaltung für zwei Frequenzen (802) ersetzt, die sowohl für die Grundfrequenz, als auch für die 2. Harmonische Anpassung zwischen dem Ausgang der 1. Stufe und dem Eingang der 2. Stufe herstellt, wobei für die Grundfrequenz und die 2. Harmonische die gleiche Gruppenlaufzeit auftreten soll, damit sie sich am Gate des Transistors (104) der 2. Stufe wieder zu einem halbsinusförmigen Signal überlagern. Signale bei der vierten und höheren Harmonischen werden in diesem Fall nicht berücksichtigt, da sie um mehr als 20dB kleiner als jenes bei der Grundfrequenz sind. Die Frequenzselektionsschaltung (107) bzw. die Schaltung (201), die für alle geraden Harmonischen einen Leerlauf und für alle ungeraden einen Kurzschluß erzeugt, wird ebenfalls durch eine Anpaßschaltung (803) ersetzt, die gegebenenfalls in an sich bekannter Weise alle geraden Harmonischen leerlaufen läßt und alle ungeraden Harmonischen kurzschließt.

In Fig. 9 ist eine mögliche Ausführungsform der Anpaßschaltung für zwei Frequenzen (802) dargestellt, die sowohl für die Grundfrequenz, als auch für die 2. Harmonische Anpassung zwischen dem Ausgang der 1. Stufe und dem Eingang der 2. Stufe herstellt. Mit dem Eingang sind ein Tiefpaßfilter (901) und ein Hochpaßfilter (906) verbunden, die die Grundfrequenz und die 2. Harmonische voneinander trennen. Mit dem zweiten Anschluß des Tiefpaßfilters (901) ist eine Anpaßschaltung für die Grundfrequenz (902) verbunden, die weiter über einen Phasenschieber (903), mit dem die erforderliche Phasenbeziehung sichergestellt wird, und eine weitere Anpaßschaltung für die Grundfrequenz (904) mit einem weiteren Tiefpaßfilter für die Grundfrequenz (905) verbunden ist, das dann weiter mit dem Ausgang der Anpaßschaltung für zwei Frequenzen (802) verbunden ist. Der zweite Anschluß des Hochpaßfilters (906) ist über eine Anpaßschaltung für die 2. Harmonische (907) mit einem weiteren Hochpaßfilter (908) verbunden, dessen zweiter Anschluß auch mit dem Ausgang der Anpaßschaltung für zwei Frequenzen (802) verbunden ist.

In Fig. 10 ist eine Ausführungsform der in Fig. 9 gezeigten Anpaßschaltung für zwei Frequenzen (802) gezeigt, die Leitungsstücke mit definierten Längen, beispielsweise in Mikrostreifenleitungstechnik, zur Trennung der Grundfrequenz und der 2. Harmonischen verwendet wobei sich alle Leitungslängenangaben auf die Wellenlänge bei der Grundfrequenz beziehen. Das Tiefpaßfilter (901) wir durch eine 1/8 Wellenlängen lange Leitung (1001), die mit dem Eingang der Anpaßschaltung für zwei Frequenzen (802) und dem Eingang der Anpaßschaltung für die Grundfrequenz (902) verbunden ist, und eine 1/4 Wellenlängen lange, kurzgeschlossene Stichleitung (1002), die gleichfalls mit dem Eingang der Anpaßschaltung für die Grundfrequenz (902) verbunden ist, realisiert. Diese kurzgeschlossene Stichleitung (1002) stellt bei der Betriebsfrequenz einen Leerlauf dar und beeinflußt die Schaltung nicht weiter, bei der 2. Harmonischen stellt sie jedoch einen Kurzschluß dar, der über die 1/8 Wellenlängen lange Leitung (1001) in einen Leerlauf am Eingang transformiert wird. In gleicher Weise funktioniert der Tiefpaß (905) beim Ausgang der Anpaßschaltung für zwei Frequenzen (802), der aus einer 1/8 Wellenlängen langen Leitung (1005), die mit dem Ausgang der Anpaßschaltung für zwei Frequenzen (802) und dem Ausgang der Anpaßschaltung für die Grundfrequenz (904) verbunden ist, und einer 1/4 Wellenlängen langen, kurzgeschlossenen Stichleitung (1006), die gleichfalls mit dem Ausgang der Anpaßschaltung für die Grundfrequenz (904) verbunden ist, besteht. Das Hochpaßfilter am Eingang (906) wird durch eine 1/4 Wellenlängen lange Leitung (1003), die mit dem Eingang der Anpaßschaltung für zwei Frequenzen (802) und dem Eingang der Anpaßschaltung für die 2. Harmonische (907) verbunden ist, und eine 1/4 Wellenlängen lange, leerlaufende Stichleitung (1004), die gleichfalls mit dem Eingang der Anpaßschaltung für die 2. Harmonische (907) verbunden ist, realisiert. Diese leerlaufende Stichleitung (1004) stellt bei der 2. Harmonischen einen Leerlauf dar und beeinflußt die Schaltung nicht weiter, bei der Grundfrequenz stellt sie einen Kurzschluß dar, der bei der Grundfrequenz über die 1/4 Wellenlängen lange Leitung (1003) in einen Leerlauf am Eingang transformiert wird. In gleicher Weise funktioniert der Hochpaß am Ausgang der Anpaßschaltung für zwei Frequenzen (802), der von einer 1/4 Wellenlängen langen Leitung (1007), die mit dem Ausgang der Anpaßschaltung für zwei Frequenzen (802) und dem Ausgang der Anpaßschaltung für die 2. Harmonische (907) verbunden ist, und einer 1/4 Wellenlängen langen, leerlaufenden Stichleitung (1008), die mit dem Ausgang der Anpaßschaltung für die 2. Harmonische (907) verbunden ist, besteht. Der Phasenschieber (903) läßt sich in dieser Ausführungsform durch ein Stück Leitung realisieren.

## Patentansprüche

1. Verfahren zur Verstärkung von Signalen hoher Leistung im Hochfrequenz- und Mikrowellenbereich mittels eines 2 stufigen Verstärkers, dadurch gekennzeichnet, daß der Transistor (104) der 2. Stufe, der in einem Klasse A Betrieb betrieben wird, mit einem halbsinusförmigen Signal angesteuert wird.

2. Verfahren nach Anspruch 1, dadurch gekennzeichnet, daß zur Erzeugung des halbsinusförmigen Signals zur Ansteuerung des Transistors (104) der 2. Stufe ein Transistorverstärker verwendet wird, der im Klasse B oder Klasse AB Betrieb betrieben wird und dessen Ausgang breitbandig mit dem Eingang des 2. Transistorverstärkers verbunden ist.

3. Vorrichtung nach den Ansprüchen 1 und 2, dadurch gekennzeichnet, daß der Eingang des Verstärkers (301) über einen Koppelkondensator (302) mit dem Gate des Transistors (304) der 1. Stufe verbunden ist, das über eine Spannungszuführung (303), die die Hochfrequenz abblockt, mit einer Gate-Source-Vorspannung beaufschlagt wird, die etwa der Abschnürspannung entspricht (Klasse B oder Klasse AB), weiters die Source des Transistors (304) der 1. Stufe mit Masse verbunden ist, und der Drain über eine Spannungszuführung (305), die wieder die Hochfrequenz abblockt, mit der positiven Versorgungsspannung verbunden ist, weiters zwischen dem Drain des Transistors (304) der 1. Stufe und dem Gate des Transistor (104) der 2. Stufe sich Koppelkondensatoren (306) und (102) und dazwischen ein mit Masse verbundener Transformator (401) befinden, der den Eingangswiderstand der 2. Stufe breitbandig auf den optimalen Lastwiderstand der 1. Stufe transformiert, weiters das Gate des Transistors der 2. Stufe über eine Spannungszuführung (103), die wieder die Hochfrequenz abblockt, mit einer Gate-Source-Vorspannung verbunden ist, die etwa 0.7 mal die Abschnürspannung beträgt (modifizierter Klasse A Betrieb) und weiters die Source des Transistor der 2. Stufe (104) wieder mit Masse verbunden ist, der Drain über eine Spannungszuführung (105), die wieder die Hochfrequenz abblockt, mit der positiven Versorgungsspannung verbunden ist, weiters der Drain des Transistors (104) der 2. Stufe über einen Koppelkondensator (106) und über eine Frequenzslektionsschaltung (107), die aus der Parallelschaltung einer Kapazität (108) und einer Induktivität (109) auf Masse besteht, welche bei der Betriebsfrequenz in Resonanz sind, mit dem Lastwiderstand (110) verbunden ist.

4. Vorrichtung nach den Ansprüchen 1 bis 3, dadurch gekennzeichnet, daß anstelle der Frequenzselektionsschaltung (107) eine an sich von den Klasse F Verstärkern bekannte Schaltung (201) verwendet wird, die alle geraden Harmonischen zwischen Drain und Source kurzschließt (202) und für alle ungeraden Harmonischen einen Leerlauf erzeugt (203).

5. Vorrichtung nach einem oder mehreren der vorhergehenden Ansprüche, dadurch gekennzeichnet, daß zwischen positiver Versorgungsspannung und Spannungszuführung (305) zum Drain des Transistors der 1. Stufe ein sehr kleiner Widerstand (601) eingefügt wird, weiters eine Diode (602) vorgesehen ist, deren Anode mit dem Widerstand (601) und der Spannungszuführung (305) zum Drain des Transistors der 1. Stufe und deren Katode mit einem sehr hohen, mit Masse verbundenen Widerstand (603) und mit der Basis eines pnp-Bipolartransistors (604) verbunden ist, dessen Emitter über einen Widerstand (607) mit der positiven Versorgungsspannung verbunden ist und dessen Kollektor über einen Widerstand (605) mit der Spannungszuführung (103) zum Gate des Transistors der 2. Stufe und von dort aus über einen weiteren Widerstand (606) mit einer negativen Versorgungsspannung verbunden ist, die etwa gleich der Abschnürspannung des Transistors (104) der 2. Stufe ist.

6. Vorrichtung nach einem oder mehreren der vorhergehenden Ansprüche, dadurch gekennzeichnet, daß der Emitter des Transistors (604) nicht wie zuvor mit einem Widerstand (607) verbunden ist, sondern mit der Spannungszuführung (105) zum Drain der 2. Stufe und mit einem sehr kleinen Widerstand (701) verbunden ist, der seinerseits wiederum mit der positiven Versorgungsspannung verbunden ist.

7. Vorrichtung nach einem oder mehreren der vorhergehenden Ansprüche, dadurch gekennzeichnet, daß zwischen dem Koppelkondensator (302) und dem Gate des Transistors (304) der 1. Stufe eine Anpaßschaltung (801) eingefügt wird, die für die Frequenz des Eingangssignals in bekannter Weise dimensioniert ist, weiters der breitbandige Transformator zwischen dem Koppelkondensator (306) am Drain der 1. Stufe und dem Koppelkondensator (102) am Gate der 2. Stufe durch eine Anpaßschaltung für zwei Frequenzen (802) ersetzt wird, die sowohl für die Grundfrequenz, als auch für die 2. Harmonische Anpassung zwischen dem Ausgang der 1. Stufe und dem Eingang der 2. Stufe herstellt, wobei für die Grundfrequenz und die 2. Harmonische die gleiche Gruppenlaufzeit auftreten soll, und auch die Frequenzselektionsschaltung (107) bzw. die Schaltung (201), die für alle geraden Harmonischen einen Leerlauf und für alle ungeraden einen Kurzschluß erzeugt, ebenfalls durch eine Anpaßschaltung (803) ersetzt wird, die gegebenenfalls in an sich bekannter Weise alle geraden Harmonischen kurzschließt und alle ungeraden Harmonischen leerlaufen läßt.

8. Vorrichtung nach einem oder mehreren der vorangegangenen Ansprüche, dadurch gekennzeichnet, daß die Anpaßschaltung für zwei Frequenzen (802) so ausgeführt wird, daß mit deren Eingang ein Tiefpaßfilter (901) und ein Hochpaßfilter (906) verbunden sind, die die Grundfrequenz und die 2. Harmonische voneinander trennen, weiters dieses Tiefpaßfilter (901) weiter mit einer Anpaßschaltung für die Grundfrequenz (902) verbunden ist, die weiter über einen Phasenschieber (903), mit dem die erforderliche Phasenbeziehung sichergestellt wird, und über eine weitere Anpaßschaltung für die Grundfrequenz (904) mit einem weiteren Tiefpaßfilter für die Grundfrequenz (905) verbunden ist, das dann weiter mit dem Ausgang der Anpaßschaltung für zwei Frequenzen (802) verbunden ist, und weiters das Hochpaßfilter (906) über eine Anpaßschaltung für die 2. Harmonische (907) mit einem weiteren Hochpaßfilter (908) verbunden ist, dessen zweiter Anschluß auch mit dem Ausgang der Anpaßschaltung für zwei Frequenzen (802) verbunden ist.

9. Vorrichtung nach einem oder mehreren der vorangegangenen Ansprüche, dadurch gekennzeichnet, daß das Tiefpaßfilter (901) durch Leitungsstücke mit definierter Länge, beispielsweise in Mikrostreifenleitungstechnik, realisiert wird, indem eine 1/8 Wellenlängen (bei der Grundfrequenz) lange Leitung (1001) den Eingang der Anpaßschaltung für zwei Frequenzen (802) mit dem Eingang der Anpaßschaltung für die Grundfrequenz (902) verbindet, und weiters eine 1/4 Wellenlängen lange, kurzgeschlossene Stichleitung (1002) am Eingang der Anpaßschaltung für die Grundfrequenz (902) angebracht wird.

10. Vorrichtung nach einem oder mehreren der vorangegangenen Ansprüche, dadurch gekennzeichnet, daß das Tiefpaßfilter (905) durch Leitungsstücke mit definierter Länge, beispielsweise in Mikrostreifenleitungstechnik, realisiert wird, indem eine 1/8 Wellenlängen lange Leitung (1005) den Ausgang der Anpaßschaltung für zwei Frequenzen (802) mit dem Ausgang der Anpaßschaltung für die Grundfrequenz (904) verbindet, und weiters eine 1/4 Wellenlängen lange, kurzgeschlossene Stichleitung (1006) am Ausgang der Anpaßschaltung für die Grundfrequenz (904) angebracht wird.

11. Vorrichtung nach einem oder mehreren der vorangegangenen Ansprüche, dadurch gekennzeichnet, daß das Hochpaßfilter (906) durch Leitungsstücke mit definierter Länge, beispielsweise in Mikrostreifenleitungstechnik, realisiert wird, indem eine 1/4 Wellenlängen lange Leitung (1003) den Eingang der Anpaßschaltung für zwei Frequenzen (802) mit dem Eingang der Anpaßschaltung für die 2. Harmonische (907) verbindet, und weiters eine 1/4 Wellenlängen lange, leerlaufende Stichleitung (1004) am Eingang der Anpaßschaltung für die 2. Harmonische (907) angebracht wird.

12. Vorrichtung nach einem oder mehreren der vorangegangenen Ansprüche, dadurch gekennzeichnet, daß das Hochpaßfilter (908) durch Leitungsstücke mit definierter Länge, beispielsweise in Mikrostreifenleitungstechnik, realsiert wird, indem eine 1/4 Wellenlängen lange Leitung (1007) den Ausgang der Anpaßschaltung für zwei Frequenzen (802) mit dem Ausgang der Anpaßschaltung für die 2. Harmonische (907) verbindet, und weiters eine 1/4 Wellenlängen lange, leerlaufende Stichleitung (1008) am Ausgang der Anpaßschaltung für die 2. Harmonische (907) angebracht wird.

**Fig. 1a**

**Fig. 1b**

**Fig. 2a**

**Fig. 2b**

**Fig. 3a**

**Fig. 3b**

**Fig. 3c**

**Fig. 4a**

**Fig. 4b**

**Fig. 4c**

**Fig. 5a**

**Fig. 5b**

Fig. 6

Fig. 7

**Fig. 8**

**Fig. 9**

**Fig. 10**

Europäisches
Patentamt

**EUROPÄISCHER RECHERCHENBERICHT**

Nummer der Anmeldung

EP 96 11 1805

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| Y | GB-A-2 075 298 (GTE LABORATORIES INC) 11.November 1981 * Seite 1, Zeile 118 - Seite 2, Zeile 99; Abbildungen 1-2C * --- | 1,2 | H03F3/193 |
| D,Y | FR-A-2 683 686 (EUROP AGENCE SPATIALE) 14.Mai 1993 | 1,2 | |
| A | * das ganze Dokument * --- | 3-8 | |
| A | MICROWAVE JOURNAL, Bd. 32, Nr. 10, 1.Oktober 1989, Seiten 103/104, 106-108, 110, 114 - 116, XP000072792 KUSHNER L J: "OUTPUT PERFORMANCE OF IDEALIZED MICROWAVE POWER AMPLIFIERS" * Seite 103 - Seite 116; Abbildungen 1-4C * --- | 1-8 | |
| A | SYMPOSIUM ON POWDER METALLURGY, Nr. 1987, 11.Juni 1987, IRON AND STEEL INSTITUTE, Seiten 490-502, XP000011737 NEELEN A H: "AN INDOOR UNIT FOR SATELLITE TV" * Seite 493, Absatz 4 - Seite 496; Abbildungen 3-6 * --- | 3 | |
| A | GB-A-2 154 819 (FERRANTI PLC) 11.September 1985 * Zusammenfassung; Abbildung 1 * --- | 5,6 | |
| A | US-A-4 268 797 (BUCK DANIEL C ET AL) 19.Mai 1981 * Spalte 2, Zeile 38 - Spalte 6, Zeile 14; Abbildungen 1,2 * ----- | 5,6 | |

RECHERCHIERTE SACHGEBIETE (Int.Cl.6)

H03F

Der vorliegende Recherchenbericht wurde für alle Patentansprüche erstellt

| Recherchenort | Abschlußdatum der Recherche | Prüfer |
|---|---|---|
| DEN HAAG | 13.November 1996 | Tyberghien, G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
............................................................
& : Mitglied der gleichen Patentfamilie, übereinstimmendes Dokument

EPO FORM 1503 03.82 (P04C03)